(19) Europäisches Patentamt / European Patent Office / Office européen des brevets

(11) **EP 2 190 117 A1**

(12) # EUROPEAN PATENT APPLICATION

(43) Date of publication:
**26.05.2010 Bulletin 2010/21**

(51) Int Cl.:
***H03H 7/38*** *(2006.01)*

(21) Application number: **09011064.4**

(22) Date of filing: **28.08.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **01.08.2008 US 184827**

(71) Applicant: **Pine Valley Investments, Inc.
Las Vegas NV 89109 (US)**

(72) Inventor: **Breslin, James
Broadale, Douglas,
Cork (IE)**

(74) Representative: **Schmidt, Steffen J.
Wuesthoff & Wuesthoff
Patent- und Rechtsanwälte
Schweigerstrasse 2
81541 München (DE)**

(54) **Dual mode output network for power amplifier**

(57) A dual mode power amplifier output network is provided that includes a load switch (55) and an auto transformer (90) having a primary winding (102) and a secondary winding (104). The load switch (55) is connected to the secondary winding (14) of the auto transformer (90).

**Description**

BACKGROUND OF THE INVENTION

This invention relates generally to auto transformers, and more particularly, to an auto transformer with load switch providing dual mode operation for a power amplifier (PA).

Auto transformers have been in use for many years. For example, auto transformers have been used as matching circuits for impedance transformation. Auto transformers have typically been implemented for DC operation to 100 MHz and are fabricated from magnetic materials to boost the inductance of the usual multi-turn design.

In wireless communications, the concept of maintaining high efficiency in both Global System for Mobile communications (GSM) and Enhanced Data rates for GSM Evolution (EDGE) modes of operation in a low band mobile phone power amplifier (PA) is achieved by changing the load impedance that the PA sees in each mode. The method employed to implement this concept is based on switching a component (e.g., one or more capacitors) in and out of the circuit. However, the problem with this implementation is that the switching in/out of the component to change the load impedance has the effect of compromising the in-band frequency performance of the PA. Moreover, if the component is switched into the circuit (i.e., connecting the component to the circuit using a switching means) at the 50 ohm end of a matching circuit, the switching causes general frequency shift and slope in the pass band (although the far out harmonic performance is improved).

Known circuits for switching loads at the high voltage end (50 ohms) of a matching circuit that have a pass band frequency shift have difficulty maintaining harmonic rejection. For example, rejection of the 2nd harmonics of 880-915MHz, especially where the ETSI specification is challenging (e.g., where ETSI equals -36dBm), can be particularly difficult.

Matching circuit designs are also known where the matching circuit is formed from transmission line inductors and high Q chip capacitors. The overall circuit also contains some harmonic rejection elements. The conventional implementation is a layout where all components are on the top of a printed circuit board (PCB) to maintain the lowest losses and highest Q for the inductances. A problem with this design is poor utilization of area available by using only the top layer of a PCB, as well as poor functionality of the circuit. These conventional designs have DC separated from the radio frequency (RF) and simple transmission line matching circuits.

BRIEF DESCRIPTION OF THE INVENTION

In accordance with an embodiment of the invention, a power amplifier output network architecture is provided that includes a load switch and an auto transformer having a primary winding and a secondary winding. The load switch is connected to the secondary winding of the auto transformer.

BRIEF DESCRIPTION OF THE DRAWINGS

Figure1 is a simplified block diagram of a power amplifier (PA) showing an auto transformer connected to a load switch constructed in accordance with an embodiment of the invention.

Figure 2 is a diagram illustrating a layout of an auto transformer constructed in accordance with an embodiment of the invention.

Figure 3 is diagram illustrating another layout of an auto transformer constructed in accordance with an embodiment of the invention.

Figure 4 is a diagram showing circuit elements that represent a planar auto transformer constructed in accordance with an embodiment of the invention. Additionally, the arrangement and configuration of the various components described herein may be modified or change, for example, replacing certain components with other components or changing the order or relative positions of the components.

Figure 5 is an equivalent model of a planar auto transformer constructed in accordance with an embodiment of the invention.

Figure 6 is a diagram illustrating an auto transformer constructed in accordance with an embodiment of the invention connected to a load switch.

DETAILED DESCRIPTION OF THE INVENTION

The foregoing summary, as well as the following detailed description of certain embodiments of the present invention, will be better understood when read in conjunction with the appended drawings. To the extent that the figures illustrate diagrams of the functional blocks of various embodiments, the functional blocks are not necessarily indicative of the division between components. Thus, for example, one or more of the functional blocks may be implemented in a single element. It should be understood that the various embodiments are not limited to the arrangements and instrumentality shown in the drawings.

For simplicity and ease of explanation, the invention will be described herein in connection with various embodiments thereof. Those skilled in the art will recognize, however, that the features and advantages of the various embodiments may be implemented in a variety of configurations. It is to be understood, therefore, that the embodiments described herein are presented by way of illustration, not of limitation.

As used herein, an element or step recited in the singular and proceeded with the word "a" or "an" should be understood as not excluding plural said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

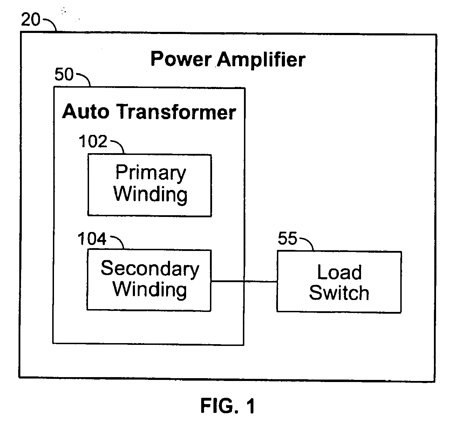

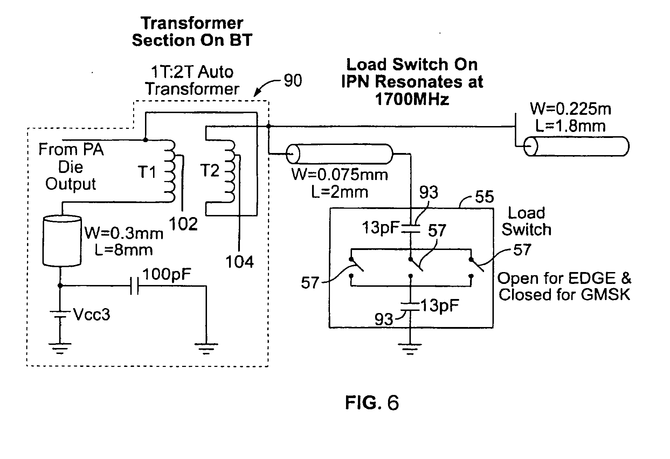

Various embodiments of the invention provide an auto transformer 50 as illustrated in Figure1 connected to a load switch 55 that may be implemented in a power amplifier (PA) 20. The PA 20 may be provided as part of, for example, a cellular telephone as is known to provide operation in two different modes, such as a Global System for Mobile communications (GSM) mode and an Enhanced Data rates for GSM Evolution (EDGE) mode. The auto transformer 50 includes a primary winding102 and a secondary winding104. The load switch 55 is connected to the secondary winding104 of the auto transformer 50 such that parasitic capacitances of the PA 20 resonate with the leakage inductance of the primary winding102 and the leakage inductance of the secondary winding104 resonates with capacitors 93 (shown in Figure 6) of the load switch 55 to form a second harmonic resonator as described in more detail below. An exemplary auto transformer 50 is described below first and followed by a description of the load switch 55 in connection with the auto transformer 55 and operation thereof.

The auto transformer 50 with a DC feed may be implemented in a planar design, and in particular, using planar inductors to minimize space utilization. The various embodiments combine the DC feed with the matching circuit component (i.e., auto transformer) that can be used, for example, in a wave shaping power amplifier, such as formed as the PA 20.

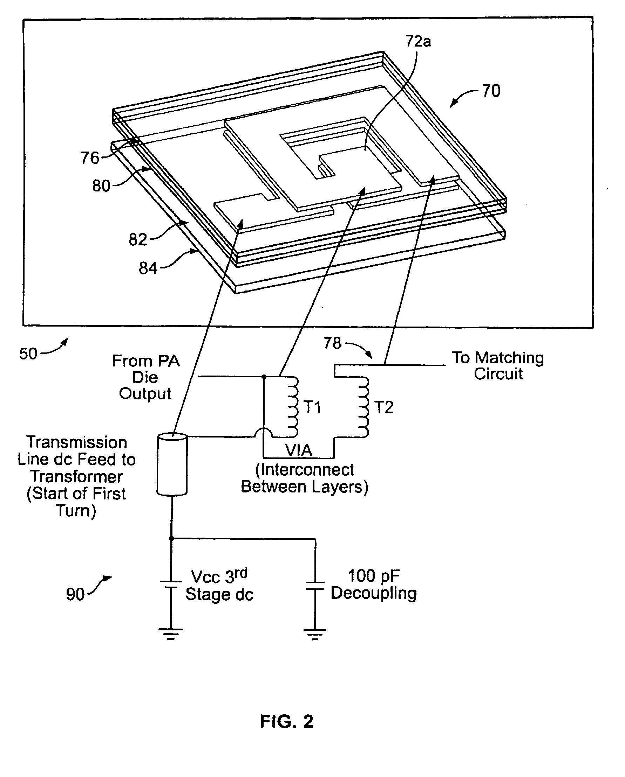

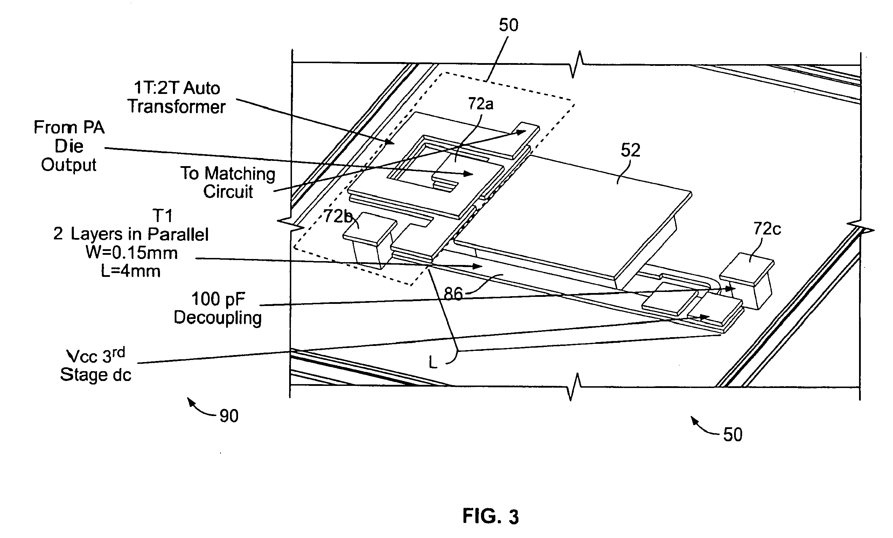

Figures 2 and 3 show two layouts of an exemplary auto transformer 50 as a transformer section on a BT laminate PCB 70. It should be noted that although specific layouts with a particular configurations and arrangements are shown, the various embodiments are not limited to the layouts shown. For example, different layouts may be used with different wave-shaping PAs. An equivalent schematic circuit 90 is also shown, which represents the circuit equivalent of the auto transformer 50 (and from which the behavior of the circuit may be determined). The auto transformer 50 is located on a four layer PCB 70 wherein only the two top layers are used to form the auto transformer 50. The auto transformer 50 is formed on these two layers above one another to maximize coupling. It should be noted that vias 72a-72c are illustrated as rectangular blocks. For example, the via 72a shown in Figures 2 and 3 is used to connect the auto transformer 50 to a DC source (not shown). Also, a die flag 52 (shown in Figure 3) defining a mounting plate is provided. The PA 20, which in one embodiment is a chip or die, is bonded onto the die flag 52 using any known and suitable bonding process.

The top layer 76 (or first layer) of the auto transformer 50, rotating clockwise in Figures 2 and 3, is the second turn of the transformer and is connected to an output 78 that is connected to a matching circuit (not shown) through the load switch 55. The next layer down, namely a second layer 80 (interconnected with the top layer 76 using the via 72a, which is also a center tap) rotating anticlockwise, directly under the top turn on the top layer 76 forms the first turn of the auto transformer 50. It should be noted that the ratio of the inductances in order to obtain a desired impedance transformation (e.g., a 4:1 transformation) is determined by the ratio of the lengths of the turns in the auto transformer 50. It also should be noted that depending upon the configuration of the layout of the auto transformer 50 on the PCB 70, a portion of a turn of the auto transformer 50 may be one layer, for example, the top layer 76 and the remainder of the turn on another layer, for example, the second layer 80. For example, the entire second turn of the auto transformer 50 may be on the top layer 76 with a portion of the first turn on the top layer 76 and then continuing on the second layer 80. The next layer down, namely the third layer 82 is unused copper, and a ground plane 84 (i.e., the fourth layer) is below the third layer 82.

Looking now to Figure 3, the first turn joins with a DC feed line 86 along the side of the die flag 52, which utilizes two layers in parallel to take the DC current both half the width of the first turn of the transformer (e.g., 300um). The length (L) of the DC feed line 86 to the PA 20 (shown in Figure1) reduces the bandwidth and return loss significantly. Also, with the addition of this DC line 86, there is a change in a coupling factor or coefficient of coupling (K) as described in more detail below.

In operation, the auto transformer 50 provides a 4:1 transformation ratio that can transform a PA impedance of 3 ohms up to 12 ohms. This 4:1 transformation ratio results from a 2:1 turn ratio of the auto transformer 50 (as described above). It should be noted that different turn ratios will result in different transformation ratios.

It should be noted that the series leakage inductance, which is undesirable, is typically high due to two factors. One factor is that the construction of the four layer laminate is not optimal for good coupling at these frequencies. The other factor is that the DC feed extends the first turn with no extra coupling to the second turn. This has the effect of adding to the leakage inductance or lack of coupling. Leakage inductance has a direct correlation to the co-efficient of coupling "K" in the equation below.

$$L_1 = LP\left(\frac{1}{K} - 1\right)$$

LP = magnetizing inductance (H)
K = coefficient of coupling

To improve the operation and reduce the series leakage inductance, small capacitors (not shown) across the output may be used from a center tap (defined by the via 72a) to ground and has the effect of reducing the leakage and increasing the bandwidth of the design.

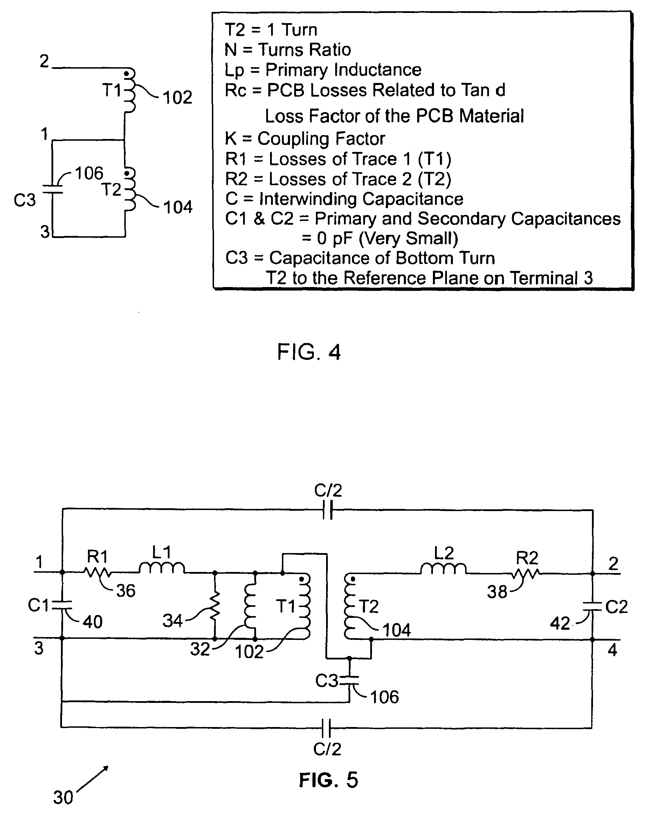

According to various embodiments, a planar auto transformer 50 implemented on printed circuit boards, for example, the PCB 70 can be represented as shown in the schematic of Figure 4, which are circuit elements that represent the planar auto transformer 50. An equivalent model 30 of the planar auto transformer 50 is shown in Figure 5. However, again, this layout is merely exemplary and may be implemented differently on printed circuit boards, for example, for different applications or with different design goals or constraints/requirements.

In particular, a model of the auto transformer 50 may be defined by a physical transformer model as shown by the equivalent model 30 of Figure 5. The model 30 is defined as follows:

Inductor (Lp) 32 = magnetizing inductance, in henries
Resistor (Rc) 34 = core loss resistance, in ohms
Resistor (R1) 36 = primary loss resistance, in ohms
Resistor (R2) 38 = secondary loss resistance, in ohms
Capacitor (C1) 40 = primary capacitance, in farads
Capacitor (C2) 42 = secondary capacitance, in farads

and wherein,

N = turns ratio N1/N2
K = coefficient of coupling
C = interwinding capacitance, in farads

Equation 1 below defines the primary leakage inductance and Equation 2 below defines the secondary leakage inductance of the model 30:

Primary leakage:

$$L_1 = LP\left(\frac{1}{K} - 1\right) \qquad \text{Equation 1}$$

Secondary leakage:

$$L_2 = \frac{L_1}{N^2}$$

Equation 2

It should be noted that C1 40 and C2 42 represent the parasitic capacitances in the auto-transformer 50. Moreover, Rc 34 represents the loss due to the PCB material, for example, Bismaleimide Triazine (BT). R1 36 and R2 38 represent the losses due to the copper in the PCB on each layer of the laminate structure. It further should be noted that the mutual and self inductances are relevant in an auto transformer design.

With turn1 (T1)102 (i.e., primary winding) and turn 2 (T2)104 (i.e., secondary winding) connected as shown in Figure 4, C1 40 and C2 42 are the same as C/2, so the values of C1 40 and C2 42 are negligible due to the physical implementation. The value of capacitor C3 106 is set as the capacitance from the turn T1 102 and the reference terminal 3. The reference terminal 3 is connected to ground through either a via or as in the wave shaping design a transmission line and capacitor, for example, a 100pF capacitor.

Having described various embodiments of auto transformers, the load switch 55 will now be described. The load switch 55 as shown in Figure 6 (that may include a plurality of switching elements 57, for example, three parallel switching elements 57) can be added to the auto transformer 50 or100. It should be noted that the load switch 55 and/or the switching elements 57 may be implemented as different types of switching devices. For example, the load switch 55 and/or the switching elements 57 may be implemented as a semiconductor device, such as a field-effect transistor (FET), a metal-oxide-semiconductor field-effect transistor (MOSFET), a metal-semiconductor field-effect transistor (MESFET) and/or as an electro-mechanical switch, micro-electromechanical (MEM) switch, a positive intrinsic negative (PIN) diode, etc.

In operation, the capacitance of the second harmonic resonator tunes the leakage inductance of the secondary winding104 of the auto transformer 50 and increases the coupling factor (k). In particular, two capacitors 93, shown as13 pico-Farad (pF) capacitors 93 connected to the load switch 55 resonate with the leakage inductance of the secondary winding104 of the auto transformer 50. Reducing the impedance seen by the PA 20 increases the power out from the PA 20. In a cellular telephone application, for example, the load switch 55 is conducting (i.e., switched on such that the capacitors 93 are connected to the secondary winding104) when operating in a GSM mode and not conducting (i.e., switched off such that the capacitors 93 are not connected to the secondary winding104) in an EDGE mode. Thus, this means that for maximum power, for example in the GSM mode, the load switch 55 is conducting and for reduced power, for example, in the EDGE mode, the load switch 55 is not conducting.

It should be noted that the load switch 55 may be implemented, for example, using a pHEMT process and to achieve a low loss through path in GSM mode. The load switch 55 may include any number of switching elements 57, for example, more or less than three (e.g., five switching elements 57). When the load switch 55 is off, partial isolation of the secondary winding 104 from the capacitors 93 is provided (e.g.,10 dB isolation) and consequently the load switch 55 is effectively partially conducting. When the load switch is on, the capacitors 93 are connected to the secondary winding 104. Thus, the switching affects the degree to which the capacitors 93 resonate with the leakage inductance (or current) of the secondary winding 104. Accordingly, the capacitors 93 are still partially affecting the circuit (i.e., partial isolation) and still resonate with the leakage inductance (or current) of the secondary winding 104. In one embodiment, the switching causes a 3 dB change in power in operation, for example, from a GSM mode to an EDGE mode.

High voltages are not applied to the load switch 55 as the load switch 55 is implemented at the low impedance end (around 12 ohms) of the system (even with the poor mismatches that are experienced from the antenna). There is a lower voltage swing than if the load switch 55 were connected at the 50 ohm end of system. The harmonics developed from the PA 20 are larger than any developed from the load switch 55. The load switch 55 used as the through path to ground for the second harmonic also helps short to ground any harmonics developed in the load switch 55 and PA 20, which is most relevant in the GSM mode (which is the higher power and on mode of the load switch 55). In the off mode (e.g., EDGE mode), the power is 3 dB less and the harmonics are significantly reduced. Thus, when the load switch 55 is on, the capacitors 93 resonate with the transmission line to create a high resonance circuit to short out second harmonics.

Thus, in a cellular telephone application the various embodiments may be used to control switching operation in the cellular telephone. For example, when a user is traveling within different cellular networks with a cellular telephone having the PA 20 therein, a determination is made as to the particular network in which the cellular telephone is operating, for example, if the cellular telephone has switched networks while moving or roaming. For example, if the cellular telephone has entered an EDGE network coverage area and needs to operate in an EDGE mode, then a determination is made as to whether the load switch 55 (shown in Figures1 and 7) is on. If the load switch 55 is on (i.e., conducting), for example, because the cellular telephone was communicating in a GSM network coverage area, then the load switch 55 is turned off (i.e., partially conducting). This switching is performed automatically by the cellular telephone. In one embodiment, for example, if the load switch 55 is a FET, a control line of a controller within the cellular telephone is connected to the gate of the FET. To turn off the load switch 55, a bias signal is removed from a gate of the FET. In this off state, the load switch 55 is partially conducting such that the capacitive effect of the capacitors 93 is partially included in the circuit of the PA 20 (shown in Figure1).

As another example, if the cellular telephone has entered a GSM network coverage area from an EDGE network coverage area, a determination is made as to whether the load switch 55 is off (i.e., partially conducting). If load switch 55 is off, then the load switch 55 is turned on (i.e., conducting) automatically by the cellular telephone. In this on state, the load switch 55 is conducting such that the capacitive effect of the capacitors 93 is included in the circuit of the PA 20 (shown in Figure1).

Thus, the various embodiments provide an auto transformer implemented, for example, on two layers of a System In Package (SIP) with the bottom layer or first turn doubling as half of the DC feed to the PA 20. However, any suitable chip packaging technology (other than a SIP) may be used. The remaining half of the DC feed is implemented down the side of the SIP utilizing dead space previously unused due to SIP design rules relating to the die flag to edge of SIP. The top layer of the auto transformer provides the first element of the matching circuit. The various embodiments may be implemented as a power amplifier matching circuit employed with improved wave shaping. In the wave shaping design the DC feed length is significantly shorter than a quarter wave and therefore some RF will travel down this line, which is terminated, for example with a100 pF capacitor to ground.

Various embodiments also provide a load switch connected to the secondary winding of an auto transformer, for example, the planar auto transformer of the various embodiments. However, the load switch may be connected to different types of auto transformers. In limited space applications (e.g., cellular telephone applications), the high leakages in planar auto transformers is reduced to improve the performance of the auto transformer (e.g., improve the lossy power performance).

It should be noted that modifications and variations to the various embodiments are contemplated. For example, the number, relative positioning and operating parameters of the various components may be modified based on the particular application, use, etc. The modification may be based on, for example, different desired or required operating characteristics.

Accordingly, it is to be understood that the above description is intended to be illustrative, and not restrictive. For example, the above-described embodiments (and/or aspects thereof) may be used in combination with each other. In addition, many modifications may be made to adapt a particular situation or material to the teachings of the invention without departing from its scope. Dimensions, types of materials, orientations of the various components, and the number and positions of the various components described herein are intended to define parameters of certain embodiments, and are by no means limiting and are merely exemplary embodiments. Many other embodiments and modifications within the spirit and scope of the claims will be apparent to those of skill in the art upon reviewing the above description.

The scope of the various embodiments of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, the terms "first," "second," and "third," etc., are used merely as labels, and are not intended to impose numerical requirements on their objects. Further, the limitations of the following claims are not written in means-plus-function format and are not intended to be interpreted based on 35 U.S.C. §112, sixth paragraph, unless and until such claim limitations expressly use the phrase "means for" followed by a statement of function void of further structure.

**Claims**

1. A power amplifier output network architecture comprising: a load switch; and an auto transformer having a primary winding and a secondary winding, the load switch connected to the secondary winding of the auto transformer.

2. A power amplifier output network architecture in accordance with claim 1 wherein the load switch comprises a plurality of switching elements.

3. A power amplifier output network architecture in accordance with claim 1 further comprising at least one capacitor and wherein the load switch is further connected to the at least one capacitor.

4. A power amplifier output network architecture in accordance with claim 3 wherein the at least one capacitor is connected between the load switch and the secondary winding of the auto transformer.

**5.** A power amplifier output network architecture in accordance with claim1 wherein the load switch is configured to switch between a conducting state and nonconducting state based on a mode of operation.

**6.** A power amplifier output network architecture in accordance with claim 1 further comprising at least one capacitor and connected between the load switch and the secondary winding of the auto transformer and wherein the leakage inductance of the secondary winding of the auto transformer resonates with the at least one capacitor.

**7.** A power amplifier output network architecture in accordance with claim 1 wherein parasitic capacitances resonate with the leakage inductance of the primary winding of the auto transformer.

20

**Power Amplifier**

50

**Auto Transformer**

102

Primary
Winding

104

Secondary
Winding

55

Load
Switch

**FIG. 1**

72a

70

76

80

82

84

50

From PA
Die
Output

Transmission
Line dc Feed to
Transformer
(Start of First
Turn)

78

To Matching
Circuit

T1      T2

VIA
(Interconnect
Between Layers)

90

Vcc 3$^{rd}$
Stage dc

100 pF
Decoupling

**FIG. 2**

FIG. 3

T2 = 1 Turn
N = Turns Ratio
Lp = Primary Inductance
Rc = PCB Losses Related to Tan d
    Loss Factor of the PCB Material
K = Coupling Factor
R1 = Losses of Trace 1 (T1)
R2 = Losses of Trace 2 (T2)
C = Interwinding Capacitance
C1 & C2 = Primary and Secondary Capacitances
    = 0 pF (Very Small)
C3 = Capacitance of Bottom Turn
    T2 to the Reference Plane on Terminal 3

FIG. 4

FIG. 5

**Transformer
Section On BT**

1T:2T Auto
Transformer ⟋─90

**Load Switch On
IPN Resonates at
1700MHz**

W=0.225m
L=1.8mm

From PA
Die
Output

T1    T2

W=0.075mm
L=2mm

102

93    ⌐55

Load
Switch

W=0.3mm
L=8mm

104

13pF⊒ 57

⌐57

57⌐

100pF

Vcc3

93⌐⊤13pF

Open for EDGE &
Closed for GMSK

**FIG. 6**

Europäisches
Patentamt

European
Patent Office

Office européen
des brevets

# EUROPEAN SEARCH REPORT

Application Number

EP 09 01 1064

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 03/085826 A2 (TRIQUINT SEMICONDUCTOR INC [US]) 16 October 2003 (2003-10-16) * figures 2,5 * | 1-7 | INV. H03H7/38 |
| X | US 5 619 283 A (PUGEL MICHAEL A [US]) 8 April 1997 (1997-04-08) * figure 3 * | 1-7 | |

TECHNICAL FIELDS
SEARCHED (IPC)

H03H

The present search report has been drawn up for all claims

| Place of search | Date of completion of the search | Examiner |
|---|---|---|
| The Hague | 23 March 2010 | Radomirescu, B-M |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT**
**ON EUROPEAN PATENT APPLICATION NO.**

EP 09 01 1064

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2010

| Patent document cited in search report | | Publication date | Patent family member(s) | | Publication date |
|---|---|---|---|---|---|
| WO 03085826 | A2 | 16-10-2003 | AU | 2003226009 A1 | 20-10-2003 |
| | | | US | 7102464 B1 | 05-09-2006 |
| US 5619283 | A | 08-04-1997 | CN | 1120283 A | 10-04-1996 |
| | | | DE | 69524689 D1 | 31-01-2002 |
| | | | DE | 69524689 T2 | 13-06-2002 |
| | | | EP | 0696870 A1 | 14-02-1996 |
| | | | JP | 3670350 B2 | 13-07-2005 |
| | | | JP | 8070409 A | 12-03-1996 |
| | | | SG | 54081 A1 | 16-11-1998 |

EPO FORM P0459

For more details about this annex : see Official Journal of the European Patent Office, No. 12/82